# EUROPEAN PATENT APPLICATION

(11) **EP 4 207 289 A1**
(43) Date of publication of application: **05.07.2023**
(21) Application number: 21860983.2
(22) Date of filing: 07.07.2021
(51) Int. Cl.: H01L 27/146, H04N 5/369

(54) **SEMICONDUCTOR DEVICE AND METHOD FOR MANUFACTURING SEMICONDUCTOR DEVICE**

(30) Priority: 31.08.2020 JP 2020145356
(71) Applicant: Sony Semiconductor Solutions Corporation, Atsugi-shi, Kanagawa 243-0014 (JP)
(72) Inventor: SHIGETOSHI, Takushi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/025538
(87) International publication number: WO 2022/044553

(57) **Abstract**

A semiconductor apparatus having multiple semiconductor chips stacked one on top of another improves functionality while reducing manufacturing costs.

The semiconductor chips include a light-receiving chip, a rewiring-side semiconductor chip, an intermediate semiconductor chip, through-electrodes, and rewiring. The light-receiving chip receives incident light. A wiring layer is formed on a predetermined wiring surface of the rewiring-side semiconductor chip. One of a pair of bonding surfaces of the intermediate semiconductor chip is bonded to the light-receiving chip, and the other of the pair of bonding surfaces is bonded to the rewiring-side semiconductor chip. The through-electrodes penetrate a semiconductor substrate of the intermediate semiconductor chip. The rewiring is provided on the wiring surface in a manner connecting the through-electrodes with the wiring layer.

## Description

### [Technical Field]

The present technology relates to a semiconductor apparatus. More particularly, this technology relates to a stacked semiconductor apparatus and a method for manufacturing the stacked semiconductor apparatus.

### [Background Art]

Heretofore, multilayer-structure semiconductor apparatuses having multiple semiconductor chips stacked one on top of another have been in use with a view to achieving miniaturization and higher functionality. For example, there has been proposed a semiconductor apparatus having two semiconductor chips stacked one on top of the other, with through-electrodes formed to penetrate from the surface to the back side, so that the two semiconductor chips are electrically connected by means of the through-electrodes and bumps on the back side (see NPL 1). This mode of connection is categorized into the face-to-back method.

### [Citation List]

### [Non Patent Literature]

[NPL 1]
Chien-Lin Huang, et al., A Novel Design Methodology for Hybrid Process 3D-IC, Automation and Test, 2012.

### [Summary]

### [Technical Problem]

According to the above-mentioned existing technology, the electrical connection of two semiconductor chips enables both chips to execute their processes for higher functionality of the semiconductor apparatus as a whole. However, in a case where the above semiconductor apparatus is to have a third semiconductor chip connected to surface bumps, for the purpose of improving functionality, the third semiconductor chip also needs to have through-electrodes formed for connection with the chip surface having the through-electrodes, which increases manufacturing costs. This makes it difficult to improve functionality while reducing the manufacturing costs.

The present technology has been made in view of the above circumstances and provides, as an object, a semiconductor apparatus having multiple semiconductor chips stacked one on top of another to achieve higher functionality while reducing manufacturing costs.

### [Solution to Problem]

The present technology has been made to solve the above problem. According to a first aspect of this technology, there is provided a semiconductor apparatus including a light-receiving chip configured to receive incident light, a rewiring-side semiconductor chip configured to have a wiring layer formed on a predetermined wiring surface thereof, an intermediate semiconductor chip configured such that one of a pair of bonding surfaces thereof is bonded to the light-receiving chip and the other of the pair of bonding surfaces is bonded to the rewiring-side semiconductor chip, a through-electrode configured to penetrate a semiconductor substrate of the intermediate semiconductor chip, and rewiring configured to be provided on the wiring surface in a manner connecting the through-electrode with the wiring layer. This provides an effect of reducing manufacturing costs and improving functionality.

Also according to the first aspect of this technology, the through-electrode may penetrate the semiconductor substrate of the intermediate semiconductor chip and the rewiring-side semiconductor chip in such a manner that one end of the through-electrode reaches the wiring surface. This provides an effect of reducing the number of times the through-electrodes are formed.

Also according to the first aspect of this technology, the semiconductor apparatus may further include a light-blocking film configured to block light from the wiring surface. This provides an effect of preventing malfunctions of the light-receiving chip.

Also according to the first aspect of this technology, the rewiring-side semiconductor chip may have a rectangular shape, and the through-electrodes may be arranged along a side of the rewiring-side semiconductor chip. This provides an effect of improving wiring efficiency.

Also according to the first aspect of this technology, the semiconductor apparatus may further include an insulating film configured to insulate the through-electrodes from the semiconductor substrate and from the rewiring-side semiconductor chip. This provides an effect of insulating the through-electrodes.

Also according to the first aspect of this technology, the insulating film may be a photo-sensitive resin. This provides an effect of further reducing the manufacturing costs.

Also according to the first aspect of this technology, one of the pair of bonding surfaces may be a surface on which a wiring layer of the intermediate semiconductor chip is formed, the rewiring-side semiconductor chip may be embedded in a predetermined region on a back side of the intermediate semiconductor chip as opposed to the surface thereof, and one end of the through-electrodes may reach a region other than the predetermined region on the back side. This provides an effect of lowering the level of difficulty in processing.

Also according to the first aspect of this technology, the intermediate semiconductor chip may have a rectangular shape, and the through-electrodes may be arranged along a side of the intermediate semiconductor chip. This provides an effect of improving wiring efficiency.

Also according to the first aspect of this technology, the semiconductor apparatus may further include an insulating film. One of the pair of bonding surfaces may be a surface on which a wiring layer of the intermediate semiconductor chip is formed, the rewiring-side semiconductor chip may be bonded to a predetermined region on a back side of the intermediate semiconductor chip as opposed to the surface thereof, while the insulating film may be formed over a region other than the predetermined region, the through-electrodes may include a first through-electrode that penetrates the semiconductor substrate in such a manner that one end of the first through-electrode reaches the insulating film, and the through-electrodes may further include a second through-electrode connected to one end of the first through-electrode in a manner penetrating the insulating film. This provides an effect of lowering the level of difficulty in manufacturing.

According to a second aspect of the present technology, there is provided a semiconductor apparatus manufacturing method including a first bonding step of bonding one of a pair of bonding surfaces of an intermediate semiconductor chip to a light-receiving chip that receives incident light, a second bonding step of bonding the other of the pair of bonding surfaces to a rewiring-side semiconductor chip of which a predetermined wiring surface has a wiring layer formed thereon, a through-electrode forming step of forming a through-electrode that penetrates a semiconductor substrate of the intermediate semiconductor chip, and a rewiring step of providing the wiring surface with rewiring for connecting the through-electrodes with the wiring layer. This provides an effect of reducing manufacturing costs and improving functionality.

Also according to the second aspect of this technology, the semiconductor apparatus manufacturing method may further include a through-hole forming step of forming a through-hole that penetrates the semiconductor substrate and the rewiring-side semiconductor chip. The through-electrode may be formed in the through-hole in the through-electrode forming step. This provides an effect of reducing the number of times the through-electrodes are formed.

Also according to the second aspect of this technology, the through-hole forming step may include a filling step of filling the through-hole with a photo-sensitive resin, and a lithography step of partially removing the photo-sensitive resin by photolithography. This provides an effect of further reducing the manufacturing costs.

Also according to the second aspect of this technology, the semiconductor apparatus manufacturing method may further include a recessed part forming step of forming a recessed part in a predetermined region on a back side of the intermediate semiconductor chip as opposed to a surface thereof on which a wiring layer is formed, an embedding step of embedding the rewiring-side semiconductor chip in the recessed part, and a through-hole forming step of forming a through-hole that penetrates the semiconductor substrate to reach a region other than the predetermined region on the back side. The through-electrode may be formed in the through-hole in the through-electrode forming step. This provides an effect of lowering the level of difficulty in processing.

Also according to the second aspect of this technology, the semiconductor apparatus manufacturing method may further include an insulating film forming step of forming the insulating film in a region other than the predetermined region on a back side of the intermediate semiconductor chip as opposed to a surface thereof on which a wiring layer is formed. The rewiring-side semiconductor chip may be bonded to the predetermined region on the back side in the second bonding step. The through-electrode forming step may include a first through-electrode forming step of forming a first through-electrode that penetrates the semiconductor substrate in such a manner that one end of the first through-electrode reaches the insulating film. The through-electrode forming step may further include a second through-electrode forming step of forming a second through-electrode connected to one end of the first through-electrode in a manner penetrating the insulating film. This provides an effect of lowering the level of difficulty in manufacturing.

### [Brief Description of Drawings]

[FIG. 1]

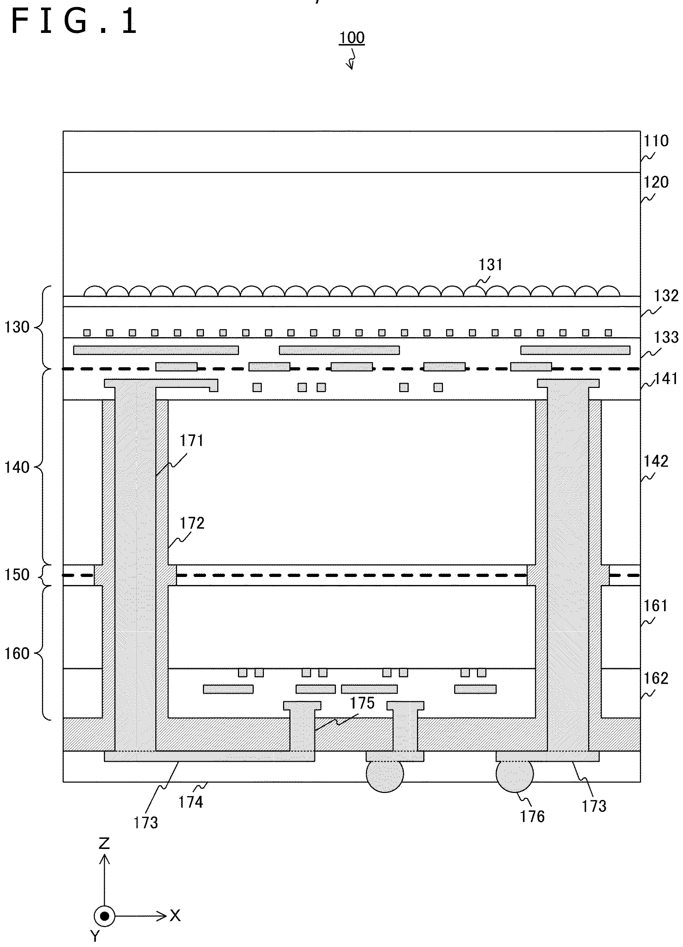

   FIG. 1 is a cross-sectional diagram depicting an exemplary configuration of a semiconductor apparatus in a first embodiment of the present technology.
[FIG. 2]

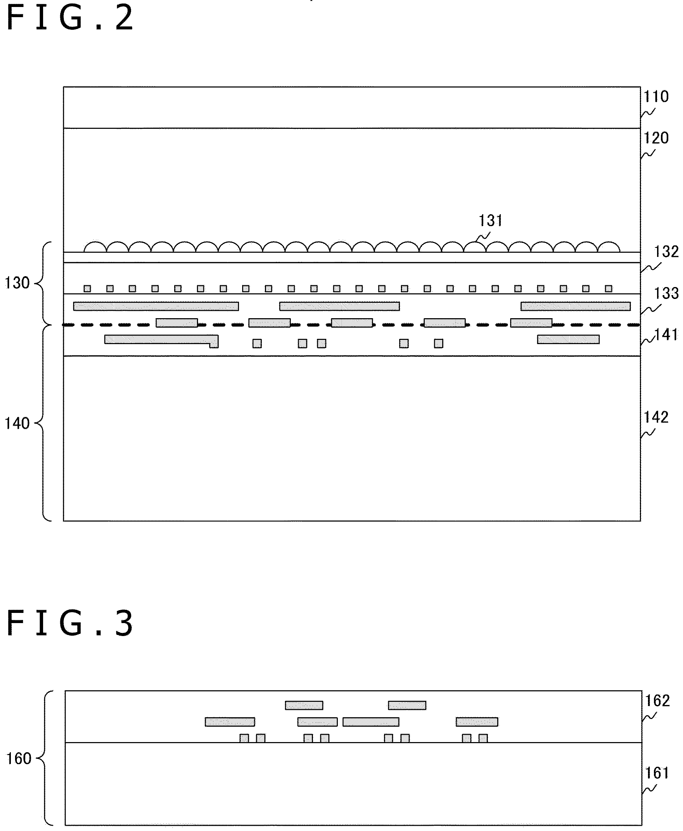

   FIG. 2 is a diagram for explaining the processes of stacking a light-receiving chip and an intermediate semiconductor chip one on top of the other in the first embodiment of the present technology.
[FIG. 3]
   FIG. 3 is a diagram for explaining the processes up to thinning a rewiring-side semiconductor chip in the first embodiment of the present technology.
[FIG. 4]

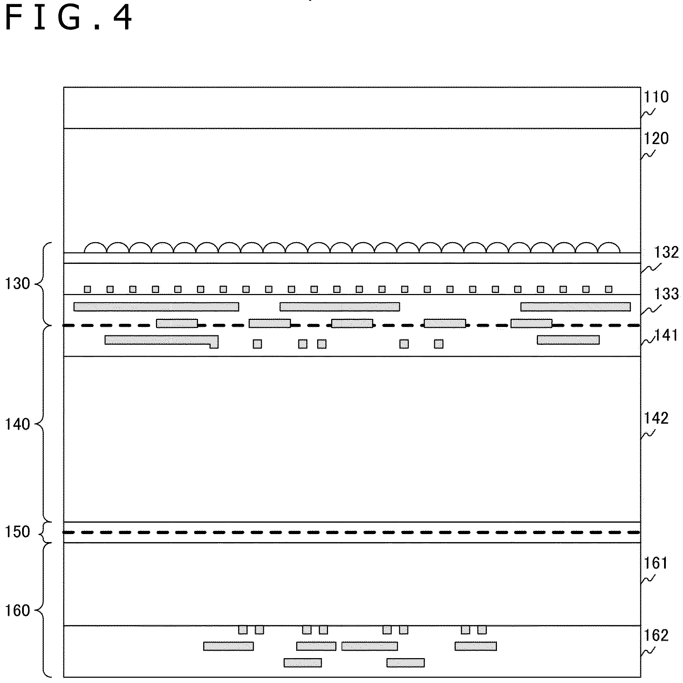

   FIG. 4 is a diagram for explaining the processes of bonding the rewiring-side semiconductor chip in the first embodiment of the present technology.
[FIG. 5]

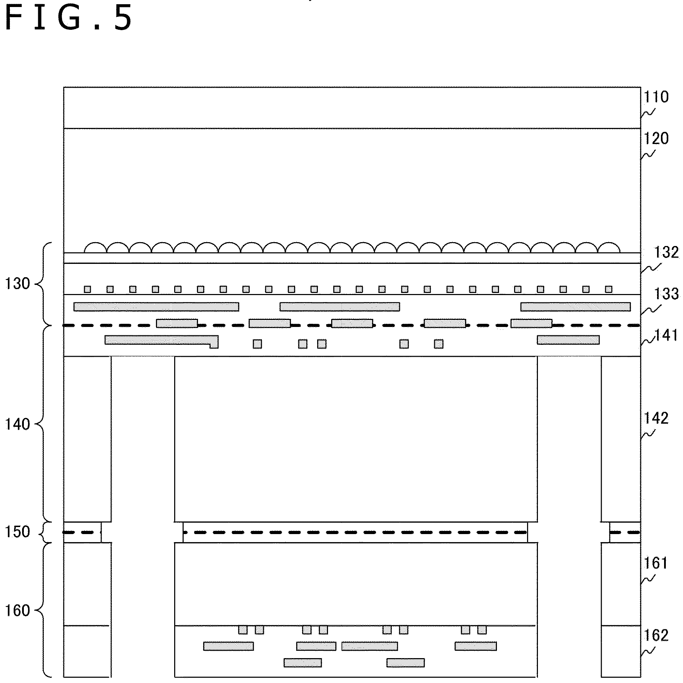

   FIG. 5 is a diagram for explaining the processes of forming through-holes in the first embodiment of the present technology.
[FIG. 6]

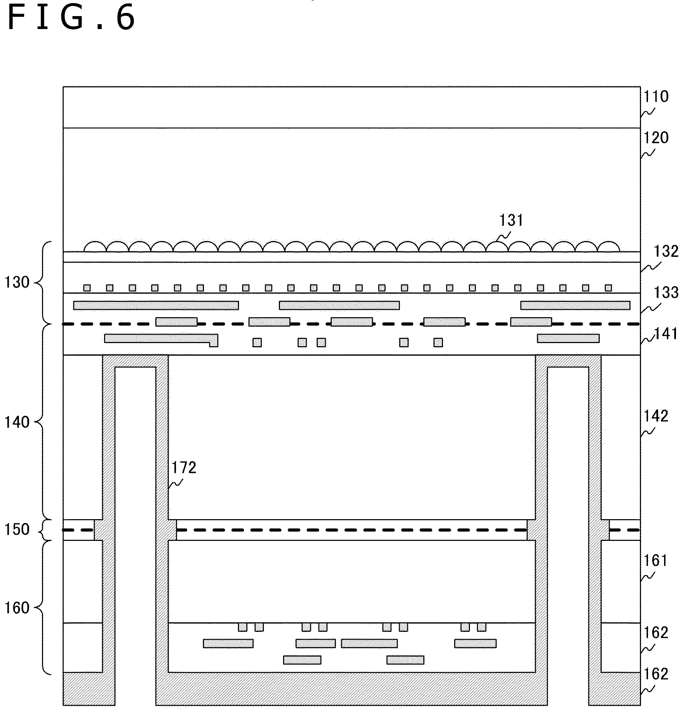

   FIG. 6 is a diagram for explaining the processes of forming an insulating film in the first embodiment of the present technology.
[FIG. 7]

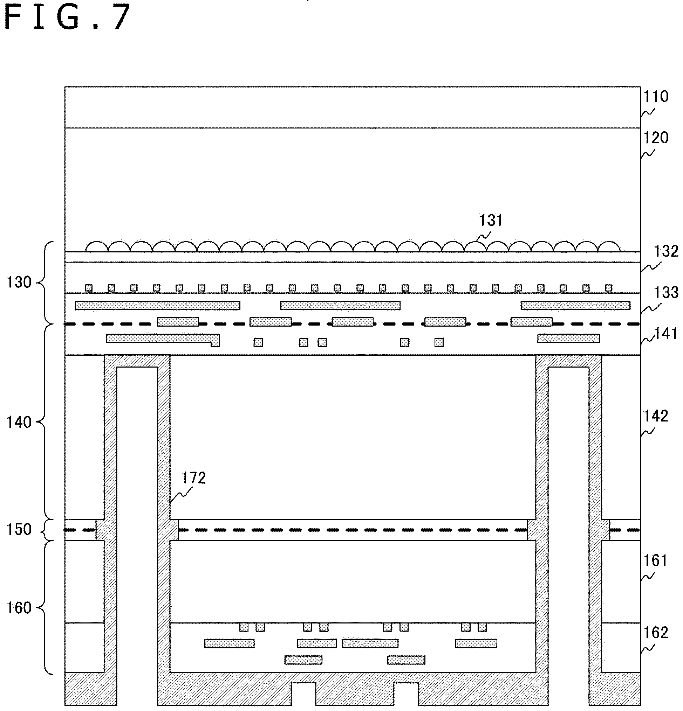

   FIG. 7 is a diagram for explaining the processes of photolithography and etching for the first embodiment of the present technology.
[FIG. 8]

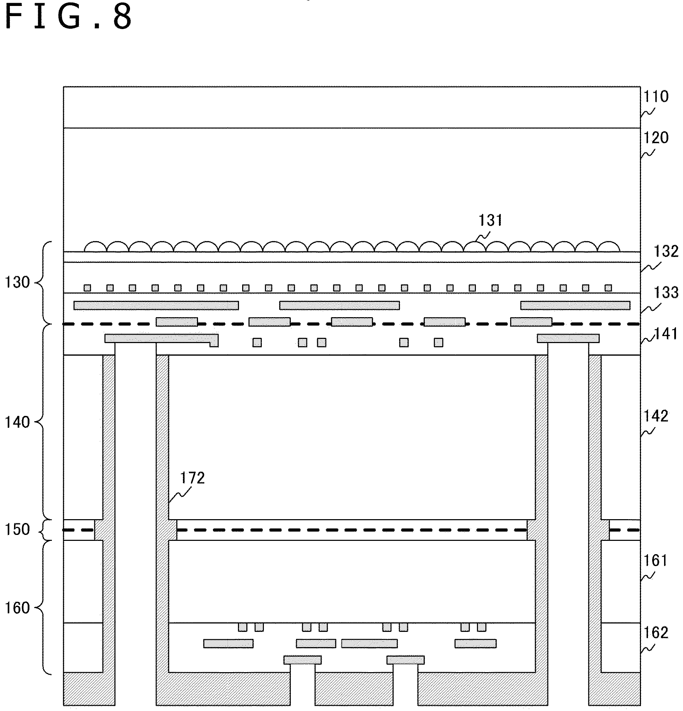

   FIG. 8 is a diagram for explaining the process of plasma etching for the first embodiment of the present technology.
[FIG. 9]

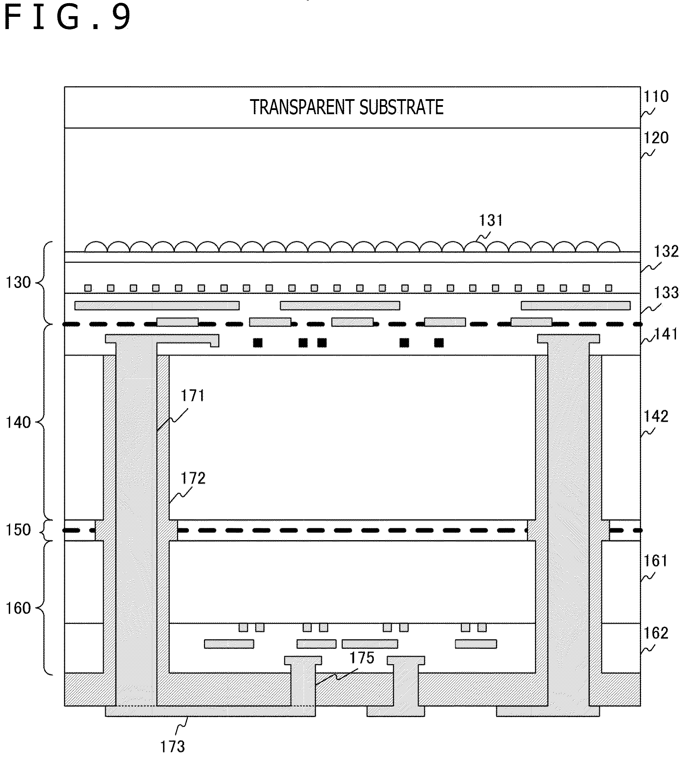

   FIG. 9 is a diagram for explaining the process of rewiring for the first embodiment of the present technology.
[FIG. 10]

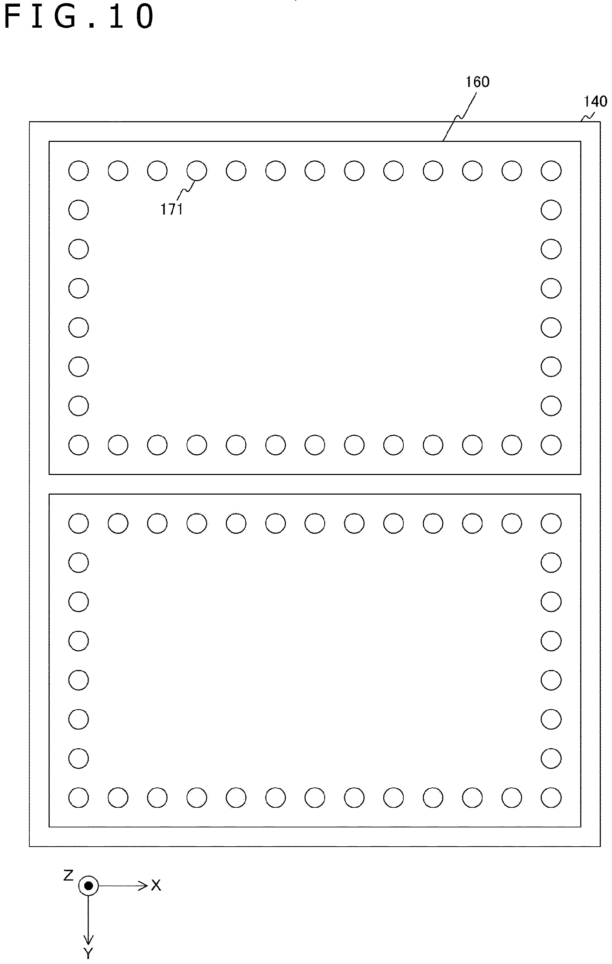

   FIG. 10 is an exemplary plan view of the semiconductor apparatus in the first embodiment of the present technology.
[FIG. 11]

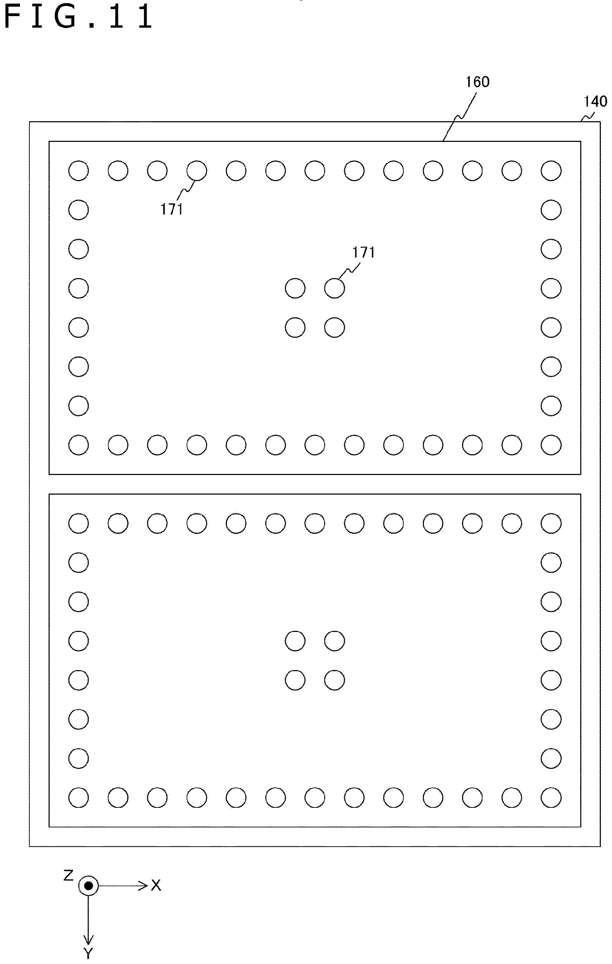

   FIG. 11 is an exemplary plan view of the semiconductor apparatus with its terminals disposed in a central part in the first embodiment of the present technology.
[FIG. 12]

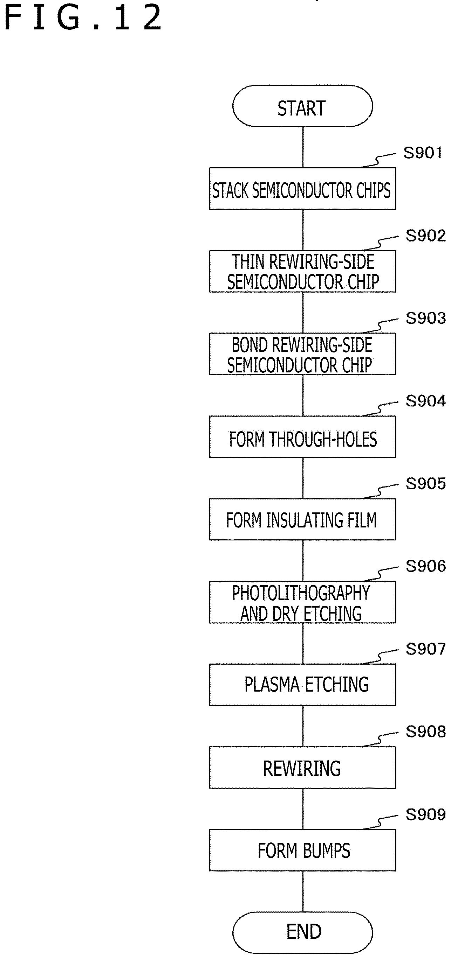

   FIG. 12 is a flowchart depicting exemplary steps pf manufacturing the semiconductor apparatus in the first embodiment of the present technology.
[FIG. 13]

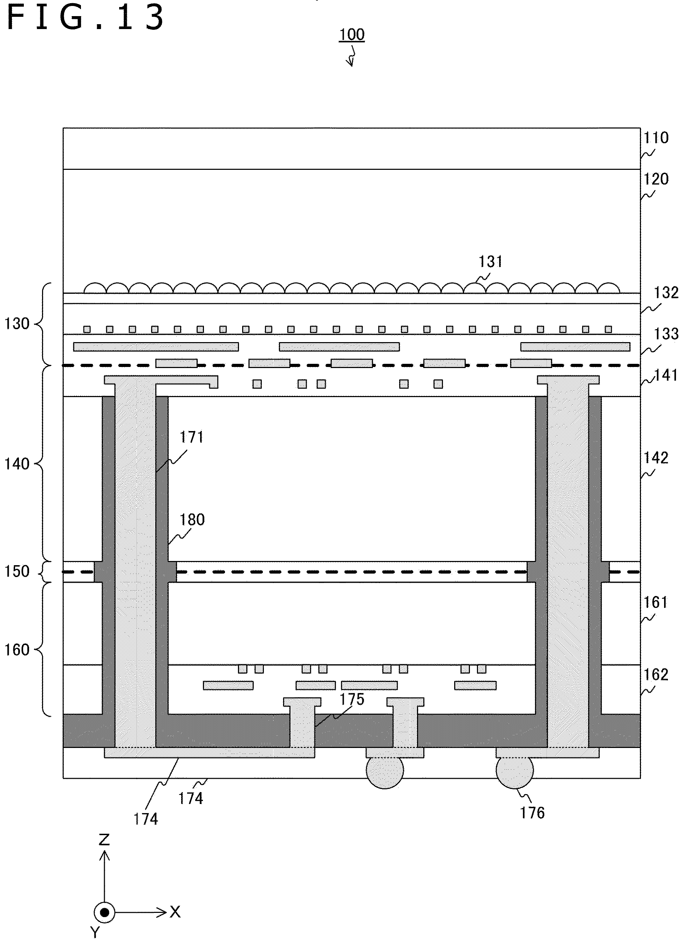

   FIG. 13 is a cross-sectional diagram depicting an exemplary configuration of a semiconductor apparatus in a second embodiment of the present technology.
[FIG. 14]

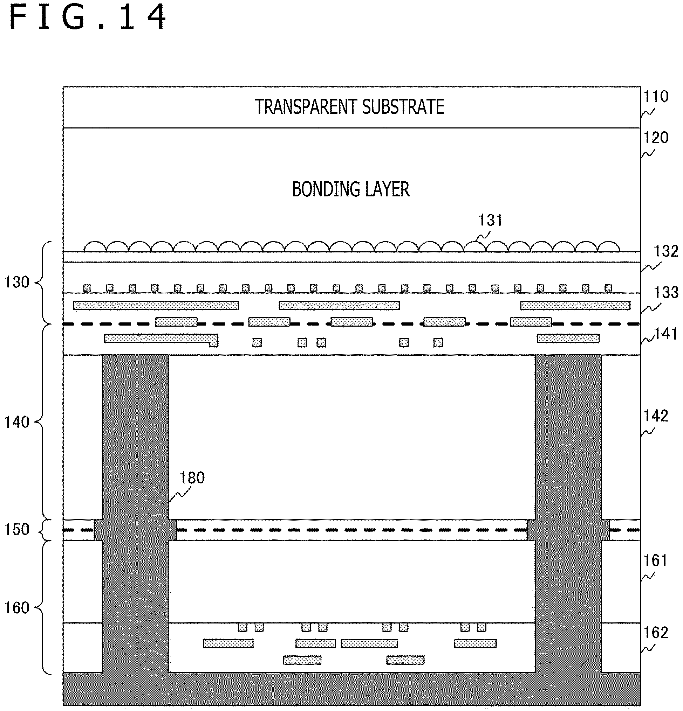

   FIG. 14 is a diagram for explaining the processes of forming an insulating film in the second embodiment of the present technology.
[FIG. 15]

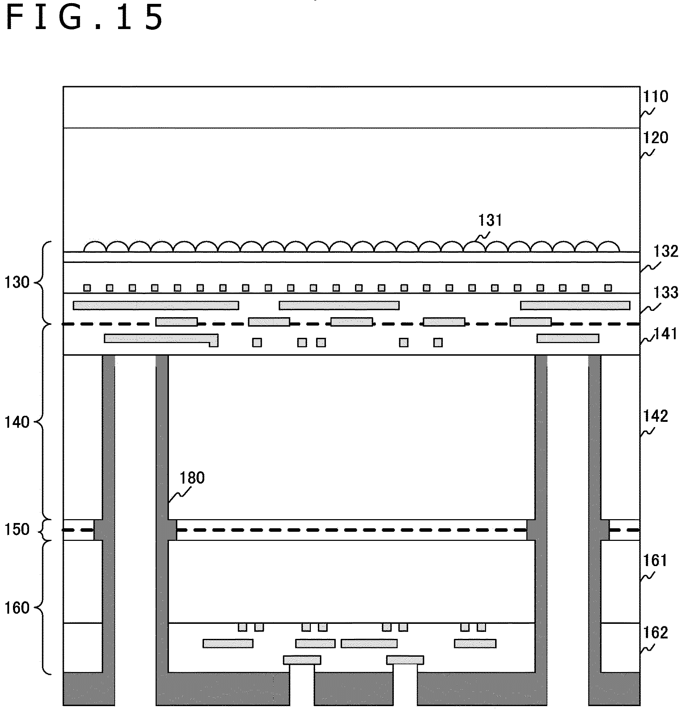

   FIG. 15 is a diagram for explaining the process of photolithography for the second embodiment of the present technology.
[FIG. 16]

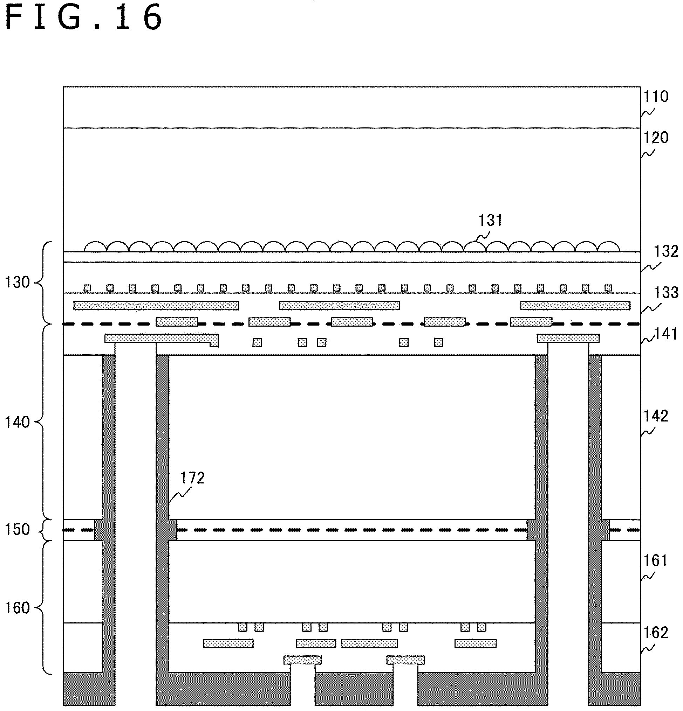

   FIG. 16 is a diagram for explaining the process of plasma etching for the second embodiment of the present technology.
[FIG. 17]

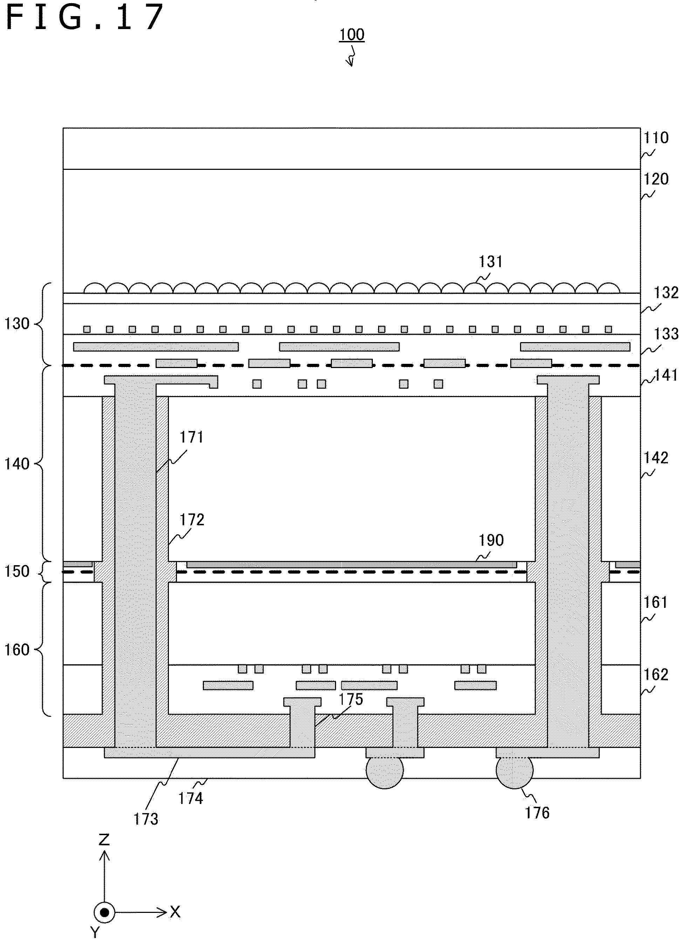

   FIG. 17 is a cross-sectional diagram depicting an exemplary configuration of a semiconductor apparatus in a third embodiment of the present technology.
[FIG. 18]

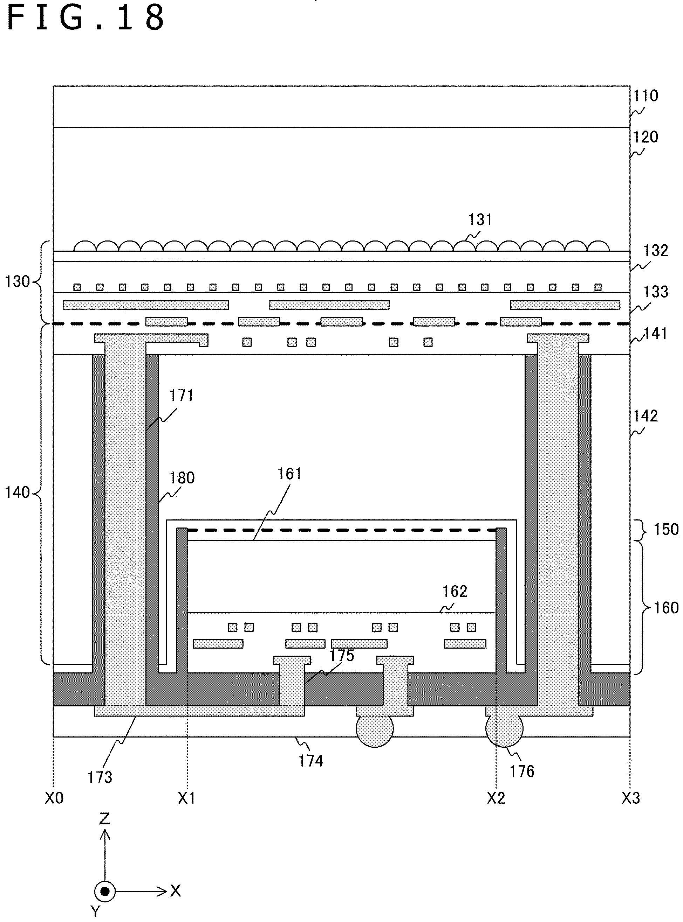

   FIG. 18 is a cross-sectional diagram depicting an exemplary configuration of a semiconductor apparatus in a fourth embodiment of the present technology.
[FIG. 19]

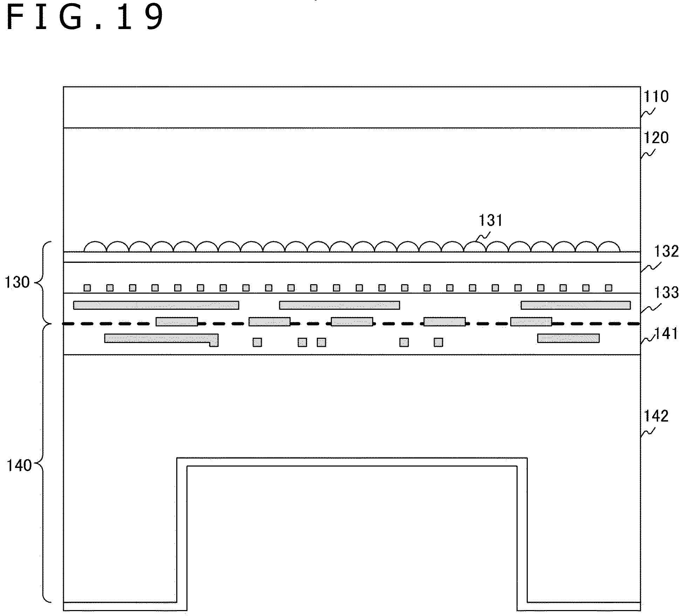

   FIG. 19 is a diagram for explaining the processes of forming a recessed part in the fourth embodiment of the present technology.
[FIG. 20]

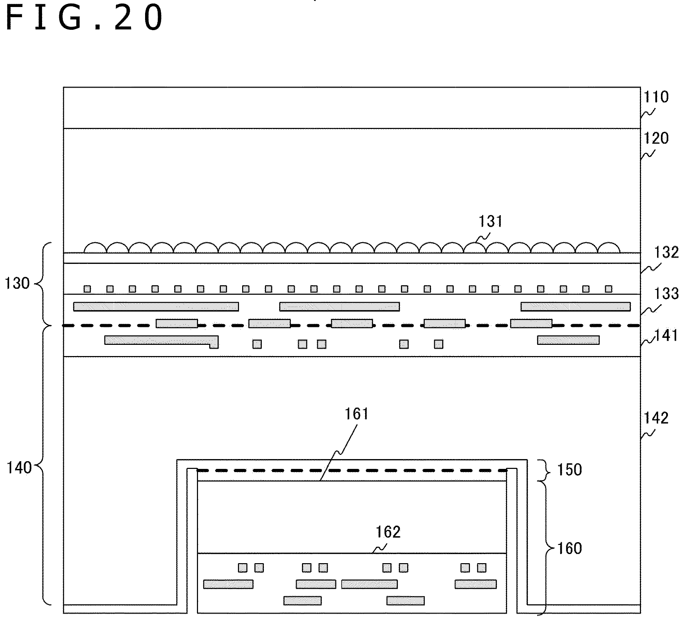

   FIG. 20 is a diagram for explaining the processes of bonding a rewiring-side semiconductor chip in the fourth embodiment of the present technology.
[FIG. 21]

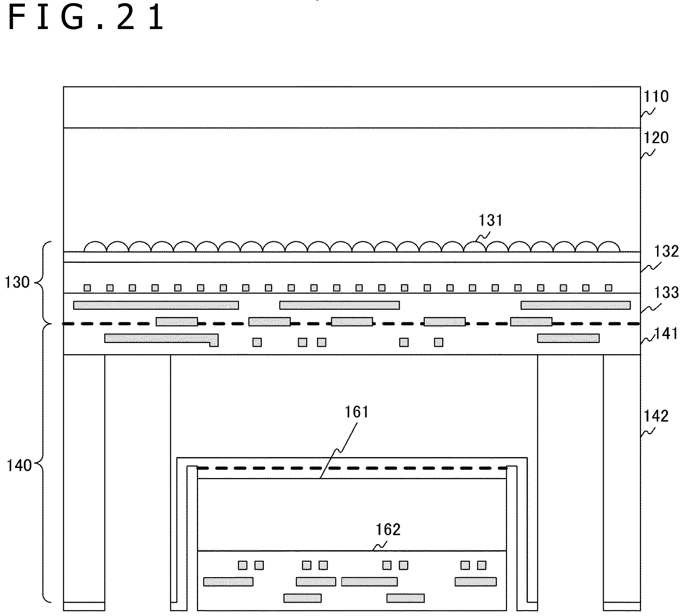

   FIG. 21 is a diagram for explaining the processes of forming through-holes in the fourth embodiment of the present technology.
[FIG. 22]

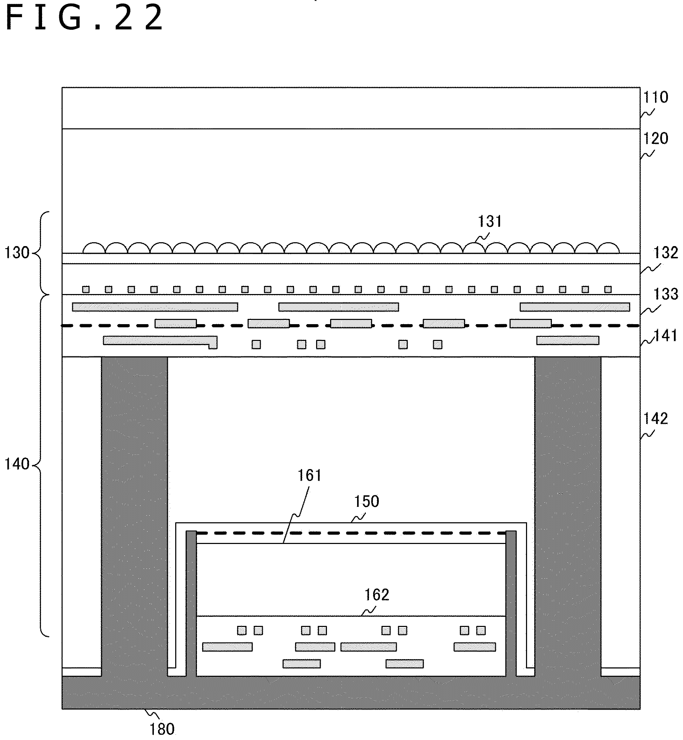

   FIG. 22 is a diagram for explaining the processes of filling using a photo-sensitive resin in the fourth embodiment of the present technology.
[FIG. 23]

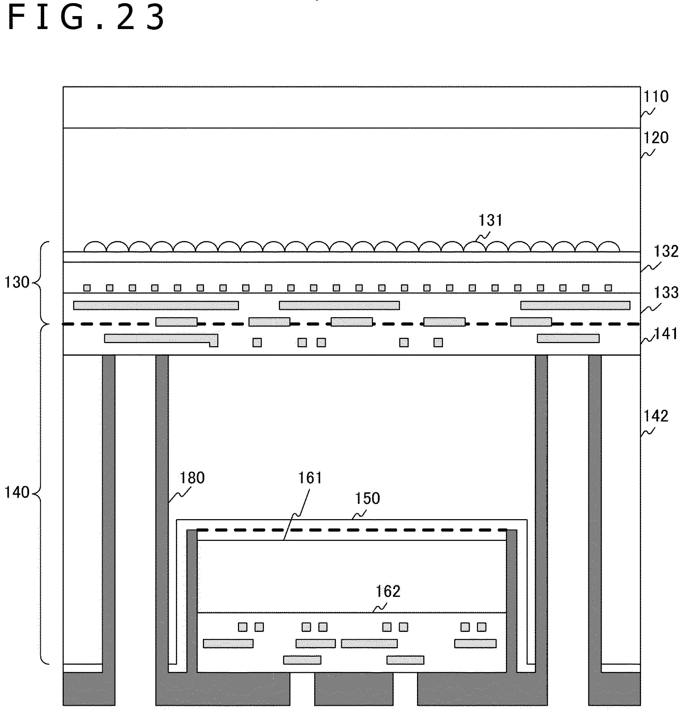

   FIG. 23 is a diagram for explaining the processes of photolithography and etching for the fourth embodiment of the present technology.
[FIG. 24]

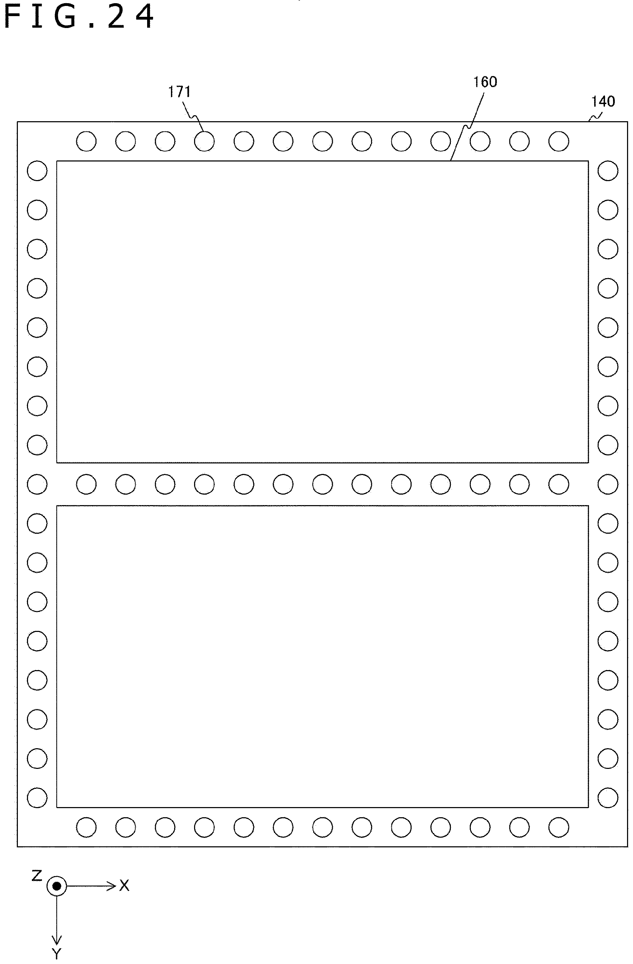

   FIG. 24 is an exemplary plan view of the semiconductor apparatus in the fourth embodiment of the present technology.
[FIG. 25]

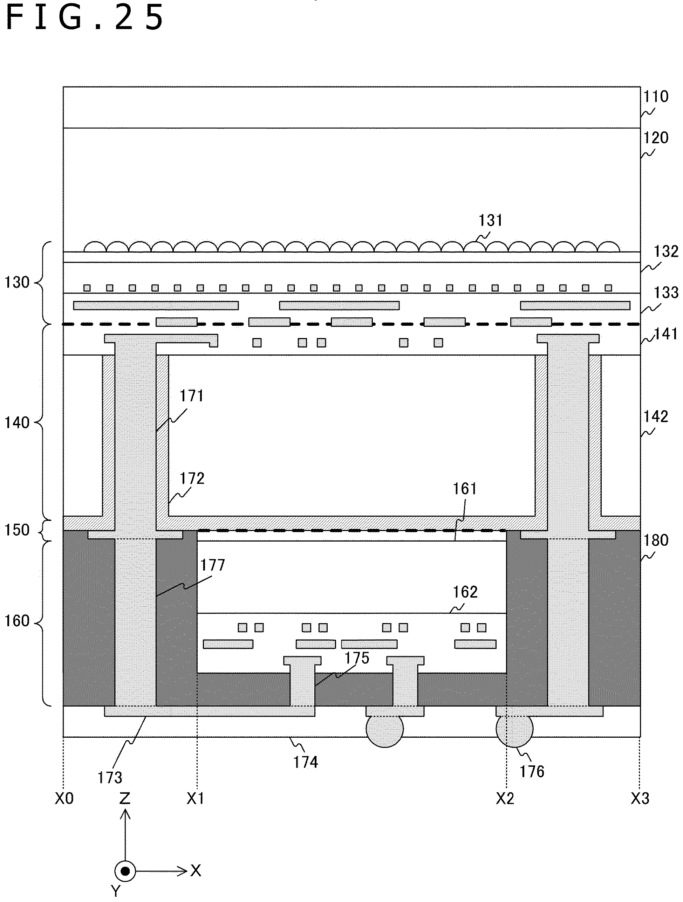

   FIG. 25 is a cross-sectional diagram depicting an exemplary configuration of a semiconductor apparatus in a fifth embodiment of the present technology.
[FIG. 26]

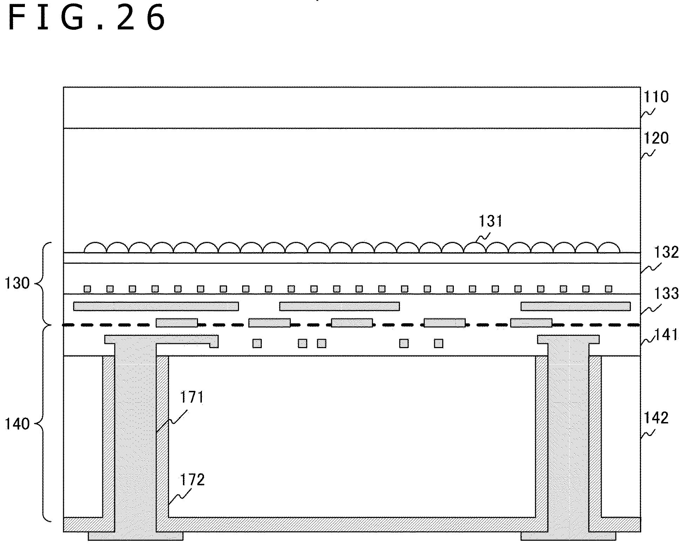

   FIG. 26 is a diagram for explaining the processes of forming through-electrodes in the fifth embodiment of the present technology.
[FIG. 27]

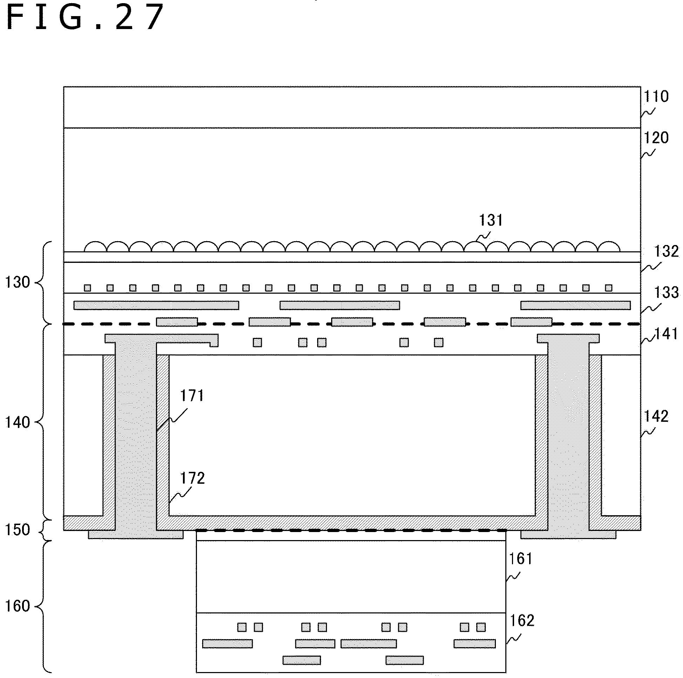

   FIG. 27 is a diagram for explaining the processes of bonding a rewiring-side semiconductor chip in the fifth embodiment of the present technology.
[FIG. 28]

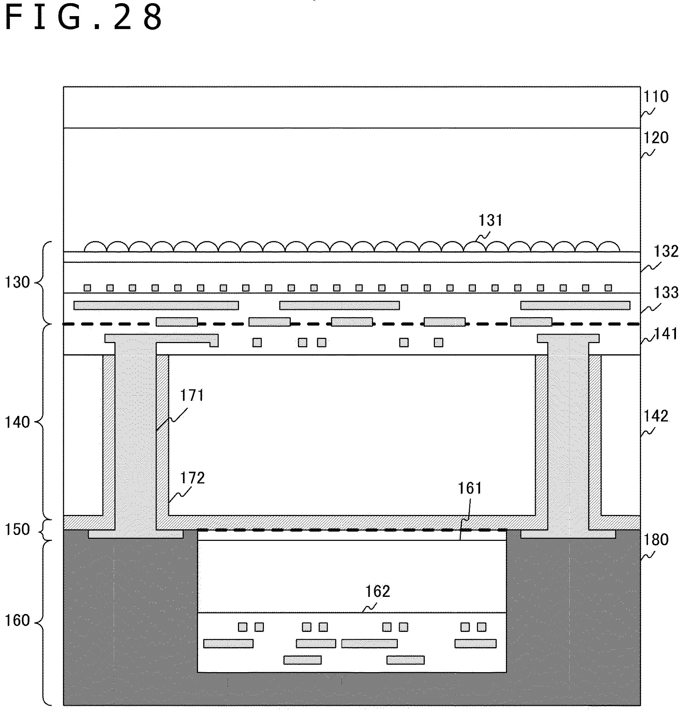

   FIG. 28 is a diagram for explaining the processes of filling using a photo-sensitive resin in the fifth embodiment of the present technology.
[FIG. 29]

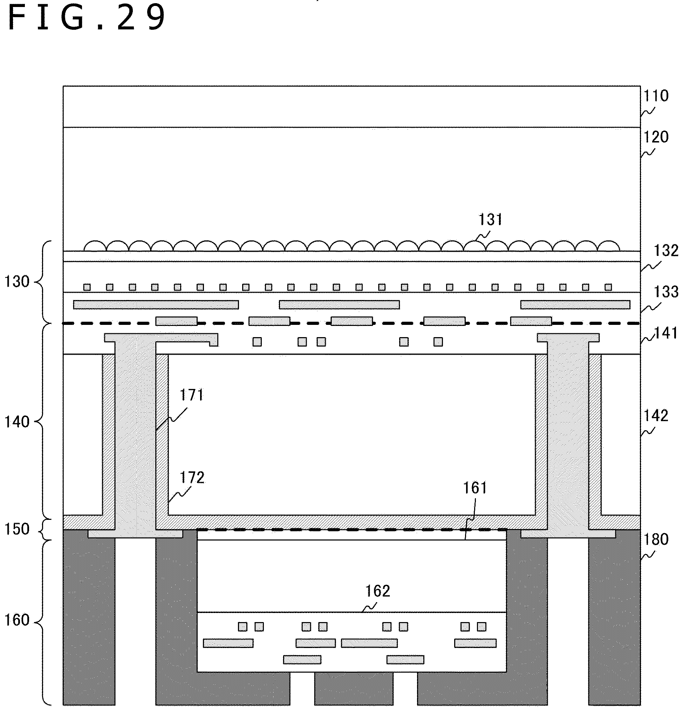

   FIG. 29 is a diagram for explaining the process of photolithography for the fifth embodiment of the present technology.
[FIG. 30]

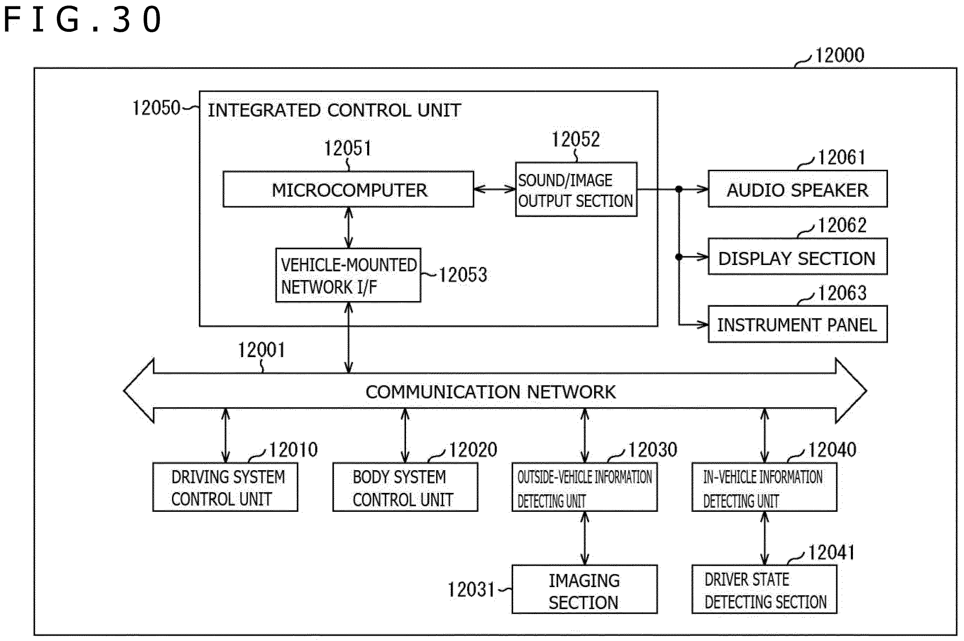

   FIG. 30 is a block diagram depicting an example of schematic configuration of a vehicle control system.
[FIG. 31]

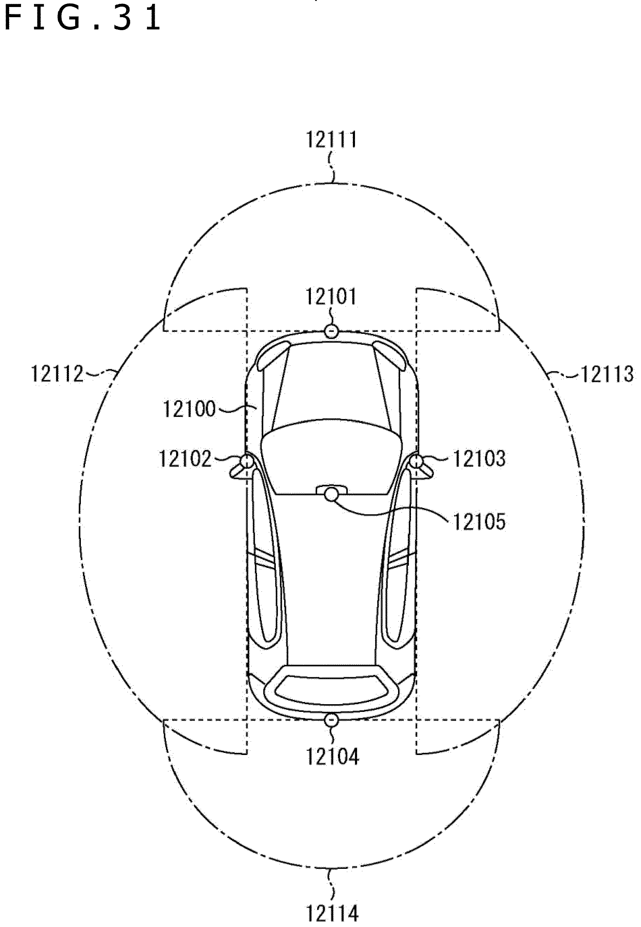

   FIG. 31 is a diagram of assistance in explaining an example of installation positions of an outside-vehicle information detecting section and an imaging section.

### [Description of Embodiments]

Some embodiments for implementing the present technology (referred to as the embodiments hereunder) are described below. The description will be made in the following order:
1. First embodiment (an example in which through-electrodes penetrate two semiconductor chips)
2. Second embodiment (an example in which a photo-sensitive resin is applied and through-electrodes penetrate two semiconductor chips)
3. Third embodiment (an example in which a light-blocking film is provided and through-electrodes penetrate two semiconductor chips)
4. Fourth embodiment (an example in which a rewiring-side semiconductor chip is embedded and through-electrodes penetrate only an intermediate semiconductor chip)
5. Fifth embodiment (an example in which the through-electrodes penetrating only the intermediate semiconductor chip are connected with the through-electrodes penetrating an insulating film)
6. Example of application to a mobile body

### <1. First embodiment>

### [Exemplary configuration of the semiconductor apparatus]

FIG. 1 is a cross-sectional diagram depicting an exemplary configuration of a semiconductor apparatus 100 in a first embodiment of the present technology. The semiconductor apparatus 100 is designed to acquire image data, and includes a light-receiving chip 130, an intermediate semiconductor chip 140, and a rewiring-side semiconductor chip 160 stacked one on top of another.

In the description that follows, the optical axis of incident light will be referred to as a "Z-axis," a predetermined axis perpendicular to the Z-axis as an "X-axis," and an axis perpendicular to both the X-axis and Z-axis as a "Y-axis." In addition, the direction toward a light-receiving surface will be regarded as the upward direction. FIG. 1 is a cross-sectional diagram as viewed from a Y direction.

The light-receiving chip 130 acquires image data by receiving incident light for photoelectric conversion. That is, the light-receiving chip 130 functions as a solid-state image pickup element. The light-receiving chip 130 includes multiple on-chip lenses 131, a semiconductor substrate 132, and a wiring layer 133.

The wiring layer 133 is formed under the semiconductor substrate 132. A reflective film and a passivation layer are formed above the semiconductor substrate 132. Color filters and the on-chip lenses 131 are disposed above the reflective film and the passivation layer. The surface on which the on-chip lenses 131 are formed is connected with a transparent substrate 110 via a bonding layer 120. The bonding layer 120 may cover either the entire on-chip lenses 131 or only their peripheries.

The intermediate semiconductor chip 140 includes a wiring layer 141 and a semiconductor substrate 142. The wiring layer 141 is formed above the top side of the semiconductor substrate 142. Further, the wiring layer 141 of the intermediate semiconductor chip 140 is bonded to the wiring layer 133 of the light-receiving chip 130. The bonding surface is indicated by a thick dotted line in FIG. 1. The intermediate semiconductor chip 140 includes, for example, a memory for holding image data and a signal processing circuit for processing the image data.

The rewiring-side semiconductor chip 160 includes a semiconductor substrate 161 and a wiring layer 162. The wiring layer 162 is formed on the underside of the semiconductor substrate 161. Further, the top side of the semiconductor substrate 161 of the rewiring-side semiconductor chip 160 is bonded to the underside of the semiconductor substrate 142 of the intermediate semiconductor chip 140 via a bonding layer 150. The bonding surface is indicated by another thick dotted line in FIG. 1.

In addition, if the side above which the wiring layer is formed on each of the light-receiving chip 130, the intermediate semiconductor chip 140, and the rewiring-side semiconductor chip 160 is regarded as the surface, incident light enters the back side of the light-receiving chip 130. A solid-state image pickup element with its back side illuminated with incident light in such a manner (i.e., light-receiving chip 130) is called the back-illuminated solid-state image pickup element.

Further, the surface of the light-receiving chip 130 is bonded to the surface of the intermediate semiconductor chip 140. The back side of the intermediate semiconductor chip 140 is bonded to the back side of the rewiring-side semiconductor chip 160. The mode of bonding the back sides of semiconductor chips as described above is called the back-to-back method. Incidentally, the surface and the back side of the intermediate semiconductor chip 140 are an example of the pair of bonding surfaces described in the appended claims.

Further, the rewiring-side semiconductor chip 160 may be connected either in a wafer state or following separation into chips smaller than the intermediate semiconductor chip 140. Moreover, whereas the intermediate semiconductor chip 140 is bonded here with the rewiring-side semiconductor chip 160 on a one-on-one basis, it is also possible to bond multiple rewiring-side semiconductor chips 160 to one intermediate semiconductor chip 140. The rewiring-side semiconductor chips 160 includes, for example, a signal processing circuit, a memory, and a temperature regulation circuit.

Materials for use as the bonding layer 150 include, for example, a bonding agent made of organic resin, inorganic matters such as silicon dioxide (SiO₂), or a stacked combination of such materials. Further, the bonding layer 150 may be provided with a light-blocking film made of aluminum (Al), titanium (Ti), tungsten (W), or a light-absorbing organic resin, as will be discussed later.

The semiconductor apparatus 100 further has through-electrodes 171 formed to extend along the Z-axis in a manner penetrating the semiconductor substrate 142 of the intermediate semiconductor chip 140, the bonding layer 150, and the rewiring-side semiconductor chip 160. One end of the through-electrodes 171 is connected with the wiring layer 141 of the intermediate semiconductor chip 140, and the other end reaches the surface of the rewiring-side semiconductor chip 160, with no physical bonding surface interposed between the two ends. The through-electrodes 171 are configured, for example, with copper (Cu), titanium (Ti), tantalum (Ta), aluminum (Al), tungsten (W), nickel (Ni), ruthenium (Ru), or cobalt (Co). Incidentally, the surface of the rewiring-side semiconductor chip 160 is an example of the wiring surface described in the appended claims.

Further, an insulating film 172 is formed between the through-electrodes 171 on one hand and the semiconductor substrate 142 and the rewiring-side semiconductor chip 160 on the other hand, thereby separating (i.e., insulating) the two portions electrically from each other. Materials for use as the insulating film 172 include silicon dioxide (SiO₂), silicon nitride (SiN), silicon oxynitride (SiON), and an inorganic film such as a low dielectric constant (Low-k) film. Whereas irregularities tend to be generated near the bonding layer 150 at the time of forming through-holes for use as the through-electrodes 171, forming the insulating film 172 mitigates such irregularities and thereby improves wiring reliability.

Here, it is preferred that the semiconductor substrate 142 of the intermediate semiconductor chip 140 be approximately 3 to 100 micrometers (µm) thick and that the bonding layer 150 be approximately 10 nanometers (nm) to 10 micrometers (µm) thick. Preferably, the rewiring-side semiconductor chip 160 may be approximately 10 to 100 micrometers (µm) thick. In view of yields and manufacturing process costs, the through-electrodes 171 may preferably be designed to be 10 to 100 micrometers (µm) in diameter and have an aspect ratio of 10 or less each.

Rewiring vias 175 are formed on the surface of the rewiring-side semiconductor chip 160, with rewiring 173 provided to connect the rewiring vias 175 to the through-electrodes 171. The intermediate semiconductor chip 140 and the rewiring-side semiconductor chip 160 are electrically connected with each other by means of the through-electrodes 171, the rewiring 173, and the rewiring vias 175. The through-electrodes 171, the rewiring 173, and the rewiring vias 175 are formed in the same process and are structured to have no bonding surfaces, which provides high reliability.

A protective layer 174 is formed under the surface over which the rewiring 173 is provided. The protective layer 174 simultaneously allows for both pad opening for connection with the rewiring vias 175 and pad opening for the wiring layer 141 of the intermediate semiconductor chip 140 at the base of the through-electrodes 171. After the opening, the pads are thus not left to corrode and result in an open failure. The rewiring 173 further has bumps 176 formed for connection with a mounting substrate. A minimum package with the size equal to that of a semiconductor chip and with the bumps 176 left exposed is called the CSP (Chip Size Package).

As depicted in FIG. 1, the rewiring-side semiconductor chip 160 stacked in addition to the light-receiving chip 130 and intermediate semiconductor chip 140 further improves the functionality of the semiconductor apparatus 100, compared with the case in which two semiconductor chips are stacked one on top of the other.

A comparative example is assumed here to be a configuration in which the through-electrodes that penetrate the semiconductor substrate 142 of the intermediate semiconductor chip 140 are formed separately from the through-electrodes that penetrate the rewiring-side semiconductor chip 160, the separately formed through-electrodes thereafter being connected. In FIG. 1, the through-electrodes 171 penetrate both the semiconductor substrate 142 of the intermediate semiconductor chip 140 and the rewiring-side semiconductor chip 160. That means the through-electrodes need only be formed in a single process, which involves less manufacturing costs than the comparative example in which the through-electrodes are required to be formed in two processes. Also, the electrodes and the wiring connections are made fewer than those in the comparative example. This makes the resistivity of the wiring paths lower than that in the comparative example, which improves the bonding strength between the semiconductor chips.

### [Method of manufacturing the semiconductor apparatus]

Explained below with reference to FIGS. 2 through 9 is the method of manufacturing the semiconductor apparatus 100. FIG. 2 is a diagram for explaining the processes of stacking the light-receiving chip 130 and the intermediate semiconductor chip 140 one on top of the other in the first embodiment of the present technology.

As depicted in FIG. 2, the manufacturing system stacks the intermediate semiconductor chip 140 on the light-receiving chip 130 in such a manner that their wiring layers are bonded facing each other, much like the existing method of making the stacked back-illuminated solid-state image pickup element into the CSP. Thereafter, the semiconductor substrate 142 of the intermediate semiconductor chip 140 is thinned to approximately 50 micrometers (µm) by wet etching, for example.

FIG. 3 is a diagram for explaining the processes up to thinning the rewiring-side semiconductor chip 160 in the first embodiment of the present technology. As depicted in FIG. 3, the rewiring-side semiconductor chip 160 is formed up to the wiring layer 162 on which pads for connection with rewiring vias are formed. Thereafter, the surface of the rewiring-side semiconductor chip 160 is covered with silicon dioxide (SiO₂). The semiconductor substrate 161 is further thinned to approximately 50 micrometers (µm) by the temporary bonding method.

FIG. 4 is a diagram for explaining the processes of bonding the rewiring-side semiconductor chip 160 in the first embodiment of the present technology. As depicted in FIG. 4, the back side of the semiconductor substrate 142 of the intermediate semiconductor chip 140 is coated with an insulating resin highly adhesive to a semiconductor substrate. Thereafter, the wafer of the rewiring-side semiconductor chip 160 is bonded, and a temporary bonding wafer is removed. Another method may involve forming a silicon oxide film over the back side of the semiconductor substrate 142 of the intermediate semiconductor chip 140 as well as over the back side of the semiconductor substrate 161 of the rewiring-side semiconductor chip 160, before bonding the two sides by plasma bonding. In any case, since the color filters of the light-receiving chip 130 (solid-state image pickup element) have a thermal resistance of up to approximately 250°C, methods of bonding at temperatures lower than that temperature are preferred.

FIG. 5 is a diagram for explaining the processes of forming through-holes in the first embodiment of the present technology. As depicted in FIG. 5, lithography and plasma etching are used to form through-holes that penetrate the semiconductor substrate 142 of the intermediate semiconductor chip 140 and the rewiring-side semiconductor chip 160.

FIG. 6 is a diagram for explaining the processes of forming the insulating film 172 in the first embodiment of the present technology. As depicted in FIG. 6, PE-CVD (Plasma Enhanced-Chemical Vapor Deposition) method and ALD (Atomic Layer Deposition) method are used to deposit the insulating film 172. In the case where resin is applied to the bonding layer 150, the bonding layer 150 tends to develop recesses at the time of forming through-holes. To avoid this problem, the recesses are filled seamlessly and unfailingly with use of the ALD method offering a high deposition coverage rate, before switching to the low-cost PE-CVD method providing a low coverage rate. This makes it possible both to improve wiring reliability through shape smoothing on the through-electrode side and to implement low-cost processing.

FIG. 7 is a diagram for explaining the processes of photolithography and etching for the first embodiment of the present technology. As depicted in FIG. 7, lithography and dry etching are used to process a back-side insulating film over the pads of the rewiring-side semiconductor chip 160 to a thickness approximately equal to that of the insulating film at the through-hole base.

FIG. 8 is a diagram for explaining the process of plasma etching for the first embodiment of the present technology. As depicted in FIG. 8, plasma etching is used to etch back the entire surface, removing the insulating film over the pads for the through-electrodes of the intermediate semiconductor chip 140 at the through-hole base as well as the insulating film over the pads of the rewiring-side semiconductor chip 160. At this time, the insulating film over the flat portion on the back side does not disappear because it is formed with a film with low coverage and is thicker than the insulating film at the through-hole base. When both sides of pads are opened in the same process, it is possible to minimize the fear of pad corrosion resulting from carrying out multiple processes following the pad opening on one side.

FIG. 9 is a diagram for explaining the process of rewiring for the first embodiment of the present technology. As depicted in FIG. 9, the rewiring 173 is formed along with the through-electrodes 171 and the rewiring vias 175 by the semi-additive process. Specifically, a barrier metal film such as tantalum (Ta) or titanium (Ti) or a copper seed metal film is formed by PVD (Physical Vapor Deposition) method, PE-CVD method, MO-CVD (Metal Organic-CVD) method, or ALD method. Then, lithography is used to form masks over unnecessary parts, before electroplating is employed to deposit a metal film on the through-electrodes 171 and on the back and front sides in a manner connecting with the top sides of the pads of the rewiring vias 175 on the rewiring-side semiconductor chip 160. Thereafter, with resist removed, wet etching is performed to remove the seed metal and the barrier metal. When the through-electrodes 171 and the rewiring 173 are formed by these processes, the rewiring vias 175 are formed concurrently with no connecting portions formed. It is also possible to form the wiring layer 162 on the back side in a multilayer structure.

After the process in FIG. 9, a protective film is formed by a solder resist on the surface of the rewired substrate (i.e., is subjected to passivation) for connection with the bumps 176 to be connected to a mounting substrate.

FIG. 10 is an exemplary plan view of the semiconductor apparatus 100 in the first embodiment of the present technology. FIG. 10 is an exemplary two-dimensional diagram as viewed from the Z-axis direction. The rewiring-side semiconductor chip 160 has a rectangular shape with a predetermined number of through-electrodes 171 disposed along the sides of the rectangle. Arranging the through-electrodes 171 along the sides in such a manner improves the wiring efficiency of the rewiring-side semiconductor chip 160. The intermediate semiconductor chip 140 and the rewiring-side semiconductor chip 160 are stacked one on top of the other on the back side of the light-receiving chip 130. Signals are transmitted between these chips via the rewiring 173. In view of this, the pads involved in the signal transmission may be positioned close to one another to shorten the signal transmission distance.

Alternatively, as exemplified in FIG. 11, the through-electrodes 171 may be further disposed in the central part of the rewiring-side semiconductor chip 160.

FIG. 12 is a flowchart depicting exemplary steps pf manufacturing the semiconductor apparatus 100 in the first embodiment of the present technology. First, the manufacturing system stacks two semiconductor chips (light-receiving chip 130 and intermediate semiconductor chip 140) one on top of the other (step S901). The rewiring-side semiconductor chip 160 is then formed and thinned (step S902). Thereafter, the rewiring-side semiconductor chip 160 is bonded (step S903).

The manufacturing system proceeds to form the through-holes (step S904) followed by the insulating film 172 (step S905). The insulating film 172 is processed by lithography and dry etching (step S906) and by plasma etching (step S907) to form the rewiring 173 along with the through-electrodes 171 and the rewiring vias 175 (step S908). The bumps 176 are then formed (step S909). At the end of step S909, the manufacturing system terminates the manufacturing processes of the semiconductor apparatus 100.

According to the first embodiment of the present technology, as described above, the rewiring-side semiconductor chip 160 is further stacked on the light-receiving chip 130 and the intermediate semiconductor chip 140. This provides higher functionality than in the case where only the light-receiving chip 130 and the intermediate semiconductor chip 140 are stacked. Moreover, because the through-electrodes 171 penetrate the semiconductor substrate 142 of the intermediate semiconductor chip 140 and the rewiring-side semiconductor chip 160, the through-electrodes are formed in a single process at the time of electrically bonding the semiconductor chips to each other. This reduces the manufacturing costs compared with the case where the through-electrodes that penetrate the semiconductor substrate 142 of the intermediate semiconductor chip 140 are formed separately from the through-electrodes that penetrate the rewiring-side semiconductor chip 160 before the through-electrodes are connected with one another.

### <2. Second embodiment>

Whereas the first embodiment discussed above uses an inorganic film such as silicon dioxide (SiO₂) as the insulating film 172, the configuration of this embodiment is not conducive to further reducing the manufacturing costs. The semiconductor apparatus 100 in a second embodiment differs from that in the first embodiment in that a photo-sensitive resin is used as the insulating film for further reduction of the manufacturing costs.

FIG. 13 is a cross-sectional diagram depicting an exemplary configuration of the semiconductor apparatus 100 in the second embodiment of the present technology. The semiconductor apparatus 100 in the second embodiment differs from that in the first embodiment in that the insulating film 172 is replaced with an insulating film 180. Materials for use as the insulating film 180 include polyimide, acrylic, silicone, and epoxy group materials.

Of the processes depicted in FIGS. 2 through 9 for the first embodiment, those in FIGS. 6 to 8 are replaced with the processes indicated in FIGS. 14 to 16 for the second embodiment.

FIG. 14 is a diagram for explaining the processes of forming the insulating film 180 in the second embodiment of the present technology. As depicted in FIG. 14, the manufacturing system applies the photo-sensitive resin (i.e., insulating film 180) onto the entire back side. The through-holes are also filled with the resin.

FIG. 15 is a diagram for explaining the process of photolithography for the second embodiment of the present technology. As depicted in FIG. 15, the photolithography process is used to remove the photo-sensitive insulating resin from the positions corresponding to the through-electrodes and to the rewiring vias.

FIG. 16 is a diagram for explaining the process of plasma etching for the second embodiment of the present technology. As depicted in FIG. 16, plasma etching is used to remove the insulating film from above the pads for the through-electrodes of the intermediate semiconductor chip 140 at the through-hole base as well as from above the pads of the rewiring-side semiconductor chip 160.

Whereas it is necessary to use the ALD and PE-CVD methods for the first embodiment, these processes are not necessary for the second embodiment because the photo-sensitive resin is used. The reduction in the number of processes further lowers the manufacturing costs. Further, the use of the coating process makes it possible to completely smooth over the irregularities of the bonding layer 150.

As described above, the second embodiment of the present technology involves using the photo-sensitive resin as the insulating film 180. The use of the photo-sensitive resin eliminates the processes that require the use of the ALD and EP-CVD methods as compared to the case where the inorganic film is utilized as the insulating film 172. This also lowers the manufacturing costs.

### <3. Third embodiment>

In the above-described first embodiment, the intermediate semiconductor chip 140 and the rewiring-side semiconductor chip 160 are bonded together with the bonding layer 150 interposed therebetween. In this configuration, however, the light from the surface of the rewiring-side semiconductor chip 160 may enter the back side of the light-receiving chip 130, possibly causing the latter to malfunction. The semiconductor apparatus 100 in a third embodiment differs from that in the first embodiment in that a light-blocking film is used to block the light from the rewiring-side semiconductor chip 160 in order to prevent chip malfunction.

FIG. 17 is a cross-sectional diagram depicting an exemplary configuration of the semiconductor apparatus 100 in the third embodiment of the present technology. The semiconductor apparatus 100 in the third embodiment is different from that in the first embodiment in that a light-blocking film 190 is further formed on the back side of the intermediate semiconductor chip 140.

The light-blocking film 190 is intended to block the light from the surface of the rewiring-side semiconductor chip 160. The light-blocking film 190 blocking the light from the surface of the rewiring-side semiconductor chip 160 prevents the light-receiving chip 130 from malfunctioning.

Alternatively, the light-blocking film 190 may be disposed on the back side of the rewiring-side semiconductor chip 160 or halfway in the bonding layer 150. As another alternative, the bonding agent of the bonding layer 150 may be used to function as the light-blocking film.

Materials for use as the light-blocking film 190 include tungsten (W), aluminum (Al), and carbon black. Preferably, holes larger in size than the through-holes may be formed in those positions of the light-blocking film 190 where the through-holes are to be formed.

As another alternative, the second embodiment may be applied to the third embodiment.

In the third embodiment of the present technology, as described above, the light-blocking film 190 is provided to block the light from the surface of the rewiring-side semiconductor chip 160. Blocking the light thus prevents chip malfunction.

### <4. Fourth embodiment>

In the above-described first embodiment, the through-electrodes 171 are formed to penetrate both the semiconductor substrate 142 of the intermediate semiconductor chip 140 and the rewiring-side semiconductor chip 160. In this configuration, however, the level of difficulty in forming the through-holes is higher than that in the case where the through-holes are formed to penetrate the semiconductor substrate 142 alone. The semiconductor apparatus 100 in a fourth embodiment differs from that in the first embodiment in that the rewiring-side semiconductor chip 160 is embedded in the semiconductor substrate 142 to make it easier to form the through-holes.

FIG. 18 is a cross-sectional diagram depicting an exemplary configuration of the semiconductor apparatus 100 in the fourth embodiment of the present technology. The semiconductor apparatus 100 in the fourth embodiment is different from that in the first embodiment in that the rewiring-side semiconductor chip 160 is embedded in the semiconductor substrate 142 of the intermediate semiconductor chip 140. Another difference from the first embodiment is the use of a photo-sensitive resin as the insulating film 180.

The rewiring-side semiconductor chip 160 has a smaller area than the intermediate semiconductor chip 140. The rewiring-side semiconductor chip 160 is thus embedded in a predetermined region on the back side of the semiconductor substrate 142. For example, it is assumed that in the X-axis direction, one edge of the back side has a coordinate of X0 and the other edge has a coordinate of X3. The rewiring-side semiconductor chip 160 is embedded in the region ranging from a coordinate of X1 to a coordinate of X2 between the above two coordinates. Further, the through-electrodes 171 penetrate only the semiconductor substrate 142. One end of the through-electrodes 171 reaches either a region having the coordinate of X0 and X1 or a region having the coordinate of X2 and X3.

With the rewiring-side semiconductor chip 160 embedded in the semiconductor substrate 142, the semiconductor chips are stacked three-dimensionally without the thickness of the chips as a whole being increased. Moreover, for the same thickness, the stacked chips are given a higher deflective strength. The through-electrodes 171 can be formed without penetrating the bonding layer 150. As a result, the level of difficulty in processing is mitigated. Further, in the case where multiple semiconductor chips formed by different forming processes are to be bonded, the level of difficulty in processing is mitigated because the processed films of the through-holes are common to the chips.

Of the processes depicted in FIGS. 2 through 9 for the first embodiment, those in FIGS. 4 through 8 are replaced with the processes in FIGS. 19 through 23 for the fourth embodiment.

FIG. 19 is a diagram for explaining the processes of forming a recessed part in the fourth embodiment of the present technology. As depicted in FIG. 19, the manufacturing system uses lithography and dry etching to form a recessed part in the semiconductor substrate 142 of the intermediate semiconductor chip 140 and deposit silicon dioxide (SiO₂) as a connection layer.

FIG. 20 is a diagram for explaining the processes of bonding the rewiring-side semiconductor chip 160 in the fourth embodiment of the present technology. As depicted in FIG. 20, an individualized rewiring-side semiconductor chip 160 is mounted in alignment with the recessed part of the semiconductor substrate 142 and bonded by the plasma bonding process.

FIG. 21 is a diagram for explaining the processes of forming through-holes in the fourth embodiment of the present technology. As depicted in FIG. 21, the through-holes are formed on the semiconductor substrate 142 of the intermediate semiconductor chip 140 by lithography and dry etching. On the back side of the intermediate semiconductor chip 140, the through-holes are formed in regions where the rewiring-side semiconductor chip 160 is not embedded.

FIG. 22 is a diagram for explaining the processes of filling using a photo-sensitive resin in the fourth embodiment of the present technology. As depicted in FIG. 22, a photo-sensitive insulating resin (insulating film 180) is applied onto the entire back side. In addition to inside the through-holes, the recessed part of the semiconductor substrate 142 of the intermediate semiconductor chip 140 and the gaps in the rewiring-side semiconductor chip 160 are also filled with the resin.

FIG. 23 is a diagram for explaining the processes of photolithography and etching for the fourth embodiment of the present technology. As depicted in FIG. 23, the photolithography process is used to remove the photo-sensitive insulating resin from the positions corresponding to the through-electrodes and the rewiring vias. Further, plasma etching is performed to remove the insulating film from above the pads for the through-electrodes of the intermediate semiconductor chip 140 at the through-hole base as well as from above the pads of the rewiring-side semiconductor chip 160.

FIG. 24 is an exemplary plan view of the semiconductor apparatus 100 in the fourth embodiment of the present technology. As depicted in FIG. 24, the rewiring-side semiconductor chip 160 is embedded in a predetermined rectangular region on the back side of the intermediate semiconductor chip 140. The through-electrodes 171 are arranged around the rectangular region.

Alternatively, the third embodiment having the light-blocking film 190 may be applied to the fourth embodiment.

According to the fourth embodiment of the present technology, as described above, the rewiring-side semiconductor chip 160 is embedded in a predetermined region of the semiconductor substrate 142 of the intermediate semiconductor chip 140, allowing the through-holes penetrating only the semiconductor substrate 142 to be formed outside the region. The level of difficulty in processing is thus lowered compared with the first embodiment in which the through-electrodes 171 penetrating both the semiconductor substrate 142 and the rewiring-side semiconductor chip 160 are formed.

### <5. Fifth embodiment>

In the above-described fourth embodiment, the rewiring-side semiconductor chip 160 is embedded in the semiconductor substrate 142 of the intermediate semiconductor chip 140. In this configuration, however, processes are needed to form the recessed part in the semiconductor substrate 142 and to embed the rewiring-side semiconductor chip 160 in the recessed part. These processes may raise the level of difficulty in manufacturing. The semiconductor apparatus 100 in a fifth embodiment differs from that in the first embodiment in that the through-electrodes 171 penetrating only the semiconductor substrate 142 are connected with through-electrodes penetrating an insulating film.

FIG. 25 is a cross-sectional diagram depicting an exemplary configuration of the semiconductor apparatus 100 in the fifth embodiment of the present technology. The semiconductor apparatus 100 in the fifth embodiment differs from the first embodiment in that through-electrodes 177 and the insulating film 180 are further formed. A photo-sensitive resin may be used as the insulating film 180, for example.

In addition, no recessed part is formed in the semiconductor substrate 142 in the fifth embodiment. The back side of the rewiring-side semiconductor chip 160 is bonded to a predetermined region (e.g., region having coordinates X1 and X2) on the back side of the semiconductor substrate 142. The insulating film 180 is formed over a region other than that region (e.g., region having coordinates X0 and X1) and over the underside of the rewiring-side semiconductor chip 160. The through-electrodes 177 penetrate the insulating film 180. One end of the through-electrodes 177 is connected with the through-electrodes 171, and the other end reaches the surface of the rewiring-side semiconductor chip 160. The other end of the through-electrodes 177 is connected with the rewiring vias 175 via the rewiring 173. In such a manner, the intermediate semiconductor chip 140 and the rewiring-side semiconductor chip 160 are electrically connected by way of the through-electrodes 171 and 177, the rewiring 173, and the rewiring vias 175.

As depicted in FIG. 25, on the back side of the semiconductor substrate 142, the insulating film 180 is formed over regions where the rewiring-side semiconductor chip 160 is not bonded. The through-electrodes 171 penetrating only the semiconductor substrate 142 are connected with the through-electrodes 177 penetrating the insulating film 180. This configuration eliminates the need for the processes that form the recessed part in the semiconductor substrate 142 and embed the rewiring-side semiconductor chip 160 in the recessed part. As a result, the level of difficulty in manufacturing the semiconductor apparatus 100 is mitigated compared with the fourth embodiment.

Of the processes depicted in FIGS. 2 through 9 for the first embodiment, those in FIGS. 4 through 9 are replaced with the processes in FIGS. 26 through 29 for the fifth embodiment.

FIG. 26 is a diagram for explaining the processes of forming the through-electrodes 171 in the fifth embodiment of the present technology. As depicted in FIG. 26, the manufacturing system thins the intermediate semiconductor chip 140 to approximately 50 micrometers (µm), forms the through-holes that penetrate the semiconductor substrate 142, and forms the insulating film 172 and the through-electrodes 171.

FIG. 27 is a diagram for explaining the processes of bonding the rewiring-side semiconductor chip 160 in the fifth embodiment of the present technology. As depicted in FIG. 27, the rewiring-side semiconductor chip 160 is bonded to a predetermined region on the back side of the intermediate semiconductor chip 140 by the plasma bonding process.

FIG. 28 is a diagram for explaining the processes of filling using a photo-sensitive resin (insulating film 180) in the fifth embodiment of the present technology. As depicted in FIG. 28, the photo-sensitive resin is applied onto regions where the rewiring-side semiconductor chip 160 is not bonded on the back side of the intermediate semiconductor chip 140 as well as onto the surface of the rewiring-side semiconductor chip 160. The photo-sensitive resin also fills the unevenness caused by the rewiring-side semiconductor chip 160.

FIG. 29 is a diagram for explaining the process of photolithography for the fifth embodiment of the present technology. As depicted in FIG. 29, the photolithography process is used to remove the photo-sensitive insulating resin from the positions where the through-electrodes 177 are to be formed and from the locations where the rewiring vias 175 of the rewiring-side semiconductor chip 160 are to be formed.

After the process of FIG. 29, the process to form the through-electrodes 177, the rewiring 173, and the rewiring vias 175 and the process to form the bumps 176 are carried out.

Alternatively, the third embodiment in which the light-blocking film 190 is additionally provided may be applied to the fifth embodiment.

According to the fifth embodiment of the present technology, as described above, the insulating film 180 is formed over regions where the rewiring-side semiconductor chip 160 is not bonded on the back side of the semiconductor substrate 142. The through-electrodes 177 penetrating the insulating film 180 are connected with the through-electrodes 171 penetrating the semiconductor substrate 142. This eliminates the need for the processes that form the recessed part in the semiconductor substrate 142 and embed the rewiring-side semiconductor chip 160 in the recessed part. As a result, the level of difficulty in manufacturing the semiconductor apparatus 100 is mitigated compared with the fourth embodiment.

### <6. Example of application to a mobile body>

The technology according to the present disclosure (present technology) can be applied to various products. For example, the technology according to the present disclosure can be implemented as an apparatus which is to be mounted on any kinds of mobile objects such as automobiles, electric vehicles, hybrid electric vehicles, motorcycles, bicycles, personal mobilities, airplanes, drones, ships, and robots.

FIG. 30 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 30, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 30, an audio speaker 12061, a display section 12062, and an instrument panel 12063 are illustrated as the output device. The display section 12062 may, for example, include at least one of an on-board display and a head-up display.

FIG. 31 is a diagram depicting an example of the installation position of the imaging section 12031.

In FIG. 31, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 31 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

Described above is one example of the vehicle control system to which the technology of the present disclosure may be applied. The technology of this disclosure may, for example, be applied advantageously to the imaging section 12031 among the above-described components. Specifically, the semiconductor apparatus 100 in FIG. 1 can be applied to the imaging section 12031. Applying the technology of the present disclosure to the imaging section 12031 improves the functionality of the latter and provides easier-to-see picked-up images. This contributes to alleviating the driver's fatigue.

Note that the embodiments described above are merely examples in which the present technology may be implemented. The particulars of the embodiments correspond basically to the inventive matters claimed in the appended claims. Likewise, the inventive matters named in the appended claims correspond basically to the particulars of the embodiments with the same names in the foregoing description of the preferred embodiments of the present technology. However, these embodiments and other examples are not limitative of the present technology that may also be implemented using various modifications and alterations of the embodiments so far as they are within the scope of the appended claims.

Note that the advantageous effects stated in this description are only examples and not limitative of the present disclosure that may provide other advantages as well.

Note that the present disclosure may also be implemented preferably in the following configurations.
(1) A semiconductor apparatus including:
   a light-receiving chip configured to receive incident light;
   a rewiring-side semiconductor chip configured to have a wiring layer formed on a predetermined wiring surface thereof;
   an intermediate semiconductor chip configured such that one of a pair of bonding surfaces thereof is bonded to the light-receiving chip and the other of the pair of bonding surfaces is bonded to the rewiring-side semiconductor chip;
   a through-electrode configured to penetrate a semiconductor substrate of the intermediate semiconductor chip; and
   rewiring configured to be provided on the wiring surface in a manner connecting the through-electrode with the wiring layer.
(2) The semiconductor apparatus as stated in paragraph (1) above, in which the through-electrode penetrates the semiconductor substrate of the intermediate semiconductor chip and the rewiring-side semiconductor chip in such a manner that one end of the through-electrode reaches the wiring surface.
(3) The semiconductor apparatus as stated in paragraph (2) above, further including:
   a light-blocking film configured to block light from the wiring surface.
(4) The semiconductor apparatus as stated in paragraph (2) or (3) above, in which the rewiring-side semiconductor chip has a rectangular shape, and
   the through-electrodes are arranged along a side of the rewiring-side semiconductor chip.
(5) The semiconductor apparatus as stated in any one of paragraphs (2) through (4) above, further including:
   an insulating film configured to insulate the through-electrodes from the semiconductor substrate and from the rewiring-side semiconductor chip.
(6) The semiconductor apparatus as stated in paragraph (5) above, in which the insulating film includes a photo-sensitive resin.
(7) The semiconductor apparatus as stated in paragraph (1) above, in which the one of the pair of bonding surfaces is a surface on which a wiring layer of the intermediate semiconductor chip is formed,
   the rewiring-side semiconductor chip is embedded in a predetermined region on a back side of the intermediate semiconductor chip as opposed to the surface thereof, and
   one end of the through-electrode reaches a region other than the predetermined region on the back side.
(8) The semiconductor apparatus as stated in paragraph (7) above, in which the intermediate semiconductor chip has a rectangular shape, and
   the through-electrodes are arranged along a side of the intermediate semiconductor chip.
(9) The semiconductor apparatus as stated in paragraph (1) above, further including:
   an insulating film,
   in which the one of the pair of bonding surfaces is a surface on which a wiring layer of the intermediate semiconductor chip is formed,
   the rewiring-side semiconductor chip is bonded to a predetermined region on a back side of the intermediate semiconductor chip as opposed to the surface thereof, while the insulating film is formed over a region other than the predetermined region, and
   the through-electrodes include
      a first through-electrode that penetrates the semiconductor substrate in such a manner that one end of the first through-electrode reaches the insulating film, and
      a second through-electrode connected to one end of the first through-electrode in a manner penetrating the insulating film.
(10) A semiconductor apparatus manufacturing method including:
   a first bonding step of bonding one of a pair of bonding surfaces of an intermediate semiconductor chip to a light-receiving chip configured to receive incident light;
   a second bonding step of bonding the other of the pair of bonding surfaces to a rewiring-side semiconductor chip of which a predetermined wiring surface has a wiring layer formed thereon;
   a through-electrode forming step of forming a through-electrode that penetrates a semiconductor substrate of the intermediate semiconductor chip; and
   a rewiring step of providing the wiring surface with rewiring for connecting the through-electrode with the wiring layer.
(11) The semiconductor apparatus manufacturing method as stated in paragraph (10) above, further including:
   a through-hole forming step of forming a through-hole that penetrates the semiconductor substrate and the rewiring-side semiconductor chip,
   in which the through-electrode is formed in the through-hole in the through-electrode forming step.
(12) The semiconductor apparatus manufacturing method as stated in paragraph (11) above, in which the through-hole forming step includes
   a filling step of filling the through-hole with a photo-sensitive resin, and
   a lithography step of partially removing the photo-sensitive resin by photolithography.
(13) The semiconductor apparatus manufacturing method as stated in paragraph (10) above, further including:
   a recessed part forming step of forming a recessed part in a predetermined region on a back side of the intermediate semiconductor chip as opposed to a surface thereof on which a wiring layer is formed;
   an embedding step of embedding the rewiring-side semiconductor chip in the recessed part; and
   a through-hole forming step of forming a through-hole that penetrates the semiconductor substrate to reach a region other than the predetermined region on the back side,
   in which the through-electrode is formed in the through-hole in the through-electrode forming step.
(14) The semiconductor apparatus manufacturing method as stated in paragraph (10) above, further including:
   an insulating film forming step of forming the insulating film in a region other than a predetermined region on a back side of the intermediate semiconductor chip as opposed to a surface thereof on which a wiring layer is formed,
   in which the rewiring-side semiconductor chip is bonded to the predetermined region on the back side in the second bonding step, and
   the through-electrode forming step includes
      a first through-electrode forming step of forming a first through-electrode that penetrates the semiconductor substrate in such a manner that one end of the first through-electrode reaches the insulating film, and
      a second through-electrode forming step of forming a second through-electrode connected to one end of the first through-electrode in a manner penetrating the insulating film.

### [Reference Signs List]

100: Semiconductor apparatus
110: Transparent substrate
120: Bonding layer
130: Light-receiving chip
131: On-chip lens
132: Semiconductor substrate
133: Wiring layer
140: Intermediate semiconductor chip
141: Wiring layer
142: Semiconductor substrate
150: Bonding layer
160: Rewiring-side semiconductor chip
161: Semiconductor substrate
162: Wiring layer
171, 177: Through-electrodes
172, 180: Insulating film
173: Rewiring
174: Protective layer
175: Rewiring vias
176: Bumps
190: Light-blocking film

## Claims

1. A semiconductor apparatus comprising:
a light-receiving chip configured to receive incident light;
a rewiring-side semiconductor chip configured to have a wiring layer formed on a predetermined wiring surface thereof;
an intermediate semiconductor chip configured such that one of a pair of bonding surfaces thereof is bonded to the light-receiving chip and the other of the pair of bonding surfaces is bonded to the rewiring-side semiconductor chip;
a through-electrode configured to penetrate a semiconductor substrate of the intermediate semiconductor chip; and
rewiring configured to be provided on the wiring surface in a manner connecting the through-electrode with the wiring layer.

2. The semiconductor apparatus according to claim 1, wherein the through-electrode penetrates the semiconductor substrate of the intermediate semiconductor chip and the rewiring-side semiconductor chip in such a manner that one end of the through-electrode reaches the wiring surface.

3. The semiconductor apparatus according to claim 2, further comprising:
a light-blocking film configured to block light from the wiring surface.

4. The semiconductor apparatus according to claim 2, wherein the rewiring-side semiconductor chip has a rectangular shape, and
the through-electrodes are arranged along a side of the rewiring-side semiconductor chip.

5. The semiconductor apparatus according to claim 2, further comprising:
an insulating film configured to insulate the through-electrodes from the semiconductor substrate and from the rewiring-side semiconductor chip.

6. The semiconductor apparatus according to claim 5, wherein the insulating film includes a photo-sensitive resin.

7. The semiconductor apparatus according to claim 1, wherein the one of the pair of bonding surfaces is a surface on which a wiring layer of the intermediate semiconductor chip is formed,
the rewiring-side semiconductor chip is embedded in a predetermined region on a back side of the intermediate semiconductor chip as opposed to the surface thereof, and
one end of the through-electrode reaches a region other than the predetermined region on the back side.

8. The semiconductor apparatus according to claim 7, wherein the intermediate semiconductor chip has a rectangular shape, and
the through-electrodes are arranged along a side of the intermediate semiconductor chip.

9. The semiconductor apparatus according to claim 1, further comprising:
an insulating film,
wherein the one of the pair of bonding surfaces is a surface on which a wiring layer of the intermediate semiconductor chip is formed,
the rewiring-side semiconductor chip is bonded to a predetermined region on a back side of the intermediate semiconductor chip as opposed to the surface thereof, while the insulating film is formed over a region other than the predetermined region, and
the through-electrodes include
a first through-electrode that penetrates the semiconductor substrate in such a manner that one end of the first through-electrode reaches the insulating film, and
a second through-electrode connected to one end of the first through-electrode in a manner penetrating the insulating film.

10. A semiconductor apparatus manufacturing method comprising:
a first bonding step of bonding one of a pair of bonding surfaces of an intermediate semiconductor chip to a light-receiving chip configured to receive incident light;
a second bonding step of bonding the other of the pair of bonding surfaces to a rewiring-side semiconductor chip of which a predetermined wiring surface has a wiring layer formed thereon;
a through-electrode forming step of forming a through-electrode that penetrates a semiconductor substrate of the intermediate semiconductor chip; and
a rewiring step of providing the wiring surface with rewiring for connecting the through-electrodes with the wiring layer.

11. The semiconductor apparatus manufacturing method according to claim 10, further comprising:
a through-hole forming step of forming a through-hole that penetrates the semiconductor substrate and the rewiring-side semiconductor chip,
wherein the through-electrode is formed in the through-hole in the through-electrode forming step.

12. The semiconductor apparatus manufacturing method according to claim 11, wherein the through-hole forming step includes
a filling step of filling the through-hole with a photo-sensitive resin, and
a lithography step of partially removing the photo-sensitive resin by photolithography.

13. The semiconductor apparatus manufacturing method according to claim 10, further comprising:
a recessed part forming step of forming a recessed part in a predetermined region on a back side of the intermediate semiconductor chip as opposed to a surface thereof on which a wiring layer is formed;
an embedding step of embedding the rewiring-side semiconductor chip in the recessed part; and
a through-hole forming step of forming a through-hole that penetrates the semiconductor substrate to reach a region other than the predetermined region on the back side,
wherein the through-electrode is formed in the through-hole in the through-electrode forming step.

14. The semiconductor apparatus manufacturing method according to claim 10, further comprising:
an insulating film forming step of forming the insulating film in a region other than a predetermined region on a back side of the intermediate semiconductor chip as opposed to a surface thereof on which a wiring layer is formed,
wherein the rewiring-side semiconductor chip is bonded to the predetermined region on the back side in the second bonding step, and
the through-electrode forming step includes
a first through-electrode forming step of forming a first through-electrode that penetrates the semiconductor substrate in such a manner that one end of the first through-electrode reaches the insulating film, and
a second through-electrode forming step of forming a second through-electrode connected to one end of the first through-electrode in a manner penetrating the insulating film.
